# EUROPEAN PATENT SPECIFICATION

(11) **EP 3 176 826 B1**
(45) Date of publication and mention of the grant of the patent: **19.08.2020**
(21) Application number: 16199570.9
(22) Date of filing: 18.11.2016
(51) Int. Cl.: H01L 27/32

(54) **DISPLAY DEVICE AND METHOD FOR MANUFACTURING THE SAME**
ANZEIGEVORRICHTUNG UND VERFAHREN ZUR HERSTELLUNG DAVON
DISPOSITIF D'AFFICHAGE ET SON PROCÉDÉ DE FABRICATION

(30) Priority: 02.12.2015 KR 20150170514
(43) Date of publication of application: 07.06.2017
(73) Proprietor: LG Display Co., Ltd., Seoul 07336 (KR)
(72) Inventor: PARK, Wonhoon, 03965 Seoul (KR); RYU, Wonsang, 10348 Goyang-si, Gyeonggi-do (KR); JO, Daegyu, 04357 Seoul (KR); SONG, Youngkyu, 403-030 Incheon (KR); SHIN, Dongchae, 10365 Goyang-si, Gyeonggi-do (KR); PYO, Seungeun, 21363 Incheon (KR)
(74) Representative: Viering, Jentschura & Partner mbB Patent- und Rechtsanwälte

(56) References cited:
- JP-A- 2004 119 599
- US-A1- 2015 060 778
- US-A1- 2015 311 260
- US-A1- 2016 233 248

## Description

### BACKGROUND OF THE INVENTION

### Field of the Invention

The present disclosure relates to a display device and a method for manufacturing the same. More specifically, the present disclosure relates to a display device and a method for manufacturing the same for preventing moisture penetration resulting from a crack generated in a scribing process. The document US2015/060778A refers to display devices.

### Discussion of the Related Art

Various display devices, which may replace cathode ray tube displays (CRTs) that are disadvantageous in terms of weight and volume, have been recently developed. Examples of such display devices include a liquid crystal display (LCD), a field emission display (FED), a plasma display panel (PDP) and an organic light emitting diode (OLED) display. An OLED display is a self-emission display device configured to emit light by exciting an organic compound. The OLED display does not require a backlight unit used in the liquid crystal display and thus can implement characteristics of thin profile and lightness in weight and simplify a manufacturing process. The OLED display can be also manufactured at a low temperature and has characteristics of a fast response time of 1 ms or less, low power consumption, a wide viewing angle, and a high contrast.

The OLED display includes a light emitting layer that is formed of an organic material, between a first electrode serving as an anode and a second electrode serving as a cathode. The OLED display forms hole-electron pairs, excitons, by combining holes received from the first electrode and electrons received from the second electrode inside the light emitting layer and emits light by energy generated when the excitons return to a ground level.

A plurality of cells is manufactured on a mother substrate and is manufactured as individual OLED displays through a scribing process for individually separating the plurality of cells. The scribing process is performed using a cutting wheel or a laser. A plurality of inorganic layers is disposed in a region of the OLED display that is cut using the wheel or the laser. When a cutting process using the cutting wheel or the laser is performed, cracks are generated in the plurality of inorganic layers. The cracks may become a moisture penetration path. Hence, the light emitting layer vulnerable to moisture is deteriorated. As a result, lifespan and reliability of the OLED display are reduced.

### SUMMARY OF THE INVENTION

The present disclosure provides a display device and a method for manufacturing the same as specifically recited in claims 1 and 6, with further advantageous embodiments recited in the dependent claims, and the invention being as specified in the set of appended claims, capable of improving lifespan and reliability by blocking a moisture penetration path formed by a crack of inorganic layers generated in a scribing process. Notwithstanding all statements in the rest of this description, the invention is to to be understood to be solely as recited in the appended claims.

In one aspect, there is provided a display device comprising a substrate including a display area having a plurality of subpixels and a bezel area around the display area, and at least one insulating layer on the substrate and having a via hole which is configured to suppress propagation of cracks in the bezel area.

In one or more embodiments, the via hole is configured to block moisture penetration through the cracks.

In one or more embodiments, the display device further comprises a passivation layer on the at least one insulating layer, the passivation layer covering the via hole and including one or more openings configured to block moisture penetrating from the edge of the display device.

In one or more embodiments, the at least one insulating layer includes at least one of a first buffer layer, a second buffer layer, a gate insulating layer, a first interlayer dielectric layer and a second interlayer dielectric layer.

In one or more embodiments, the via hole passes through the second buffer layer, the gate insulating layer, the first interlayer dielectric layer and the second interlayer dielectric layer.

In one or more embodiments, the passivation layer contacts the first buffer layer through the via hole.

In one or more embodiments, the via hole surrounds the display area.

In one or more embodiments, the one or more opening is separated from the via hole.

In one or more embodiments, the one or more opening surrounds the display area and is positioned in parallel with the via hole.

In one or more embodiments, the one or more opening and the via hole are alternately positioned.

In one or more embodiments, the one or more opening and the via hole have a loop shape from a planar perspective.

In one or more embodiments, each subpixel includes a shield layer, a semiconductor layer on the shield layer, a first gate electrode on the semiconductor layer, a second gate electrode on the first gate electrode, a source electrode connected to the semiconductor layer and the shield layer, and a drain electrode connected to the semiconductor layer.

In another aspect, there is provided a method for manufacturing a display device comprising stacking at least one insulating layer (e.g., inorganic insulating layer) on a substrate having a display area and a bezel area, and forming a via hole configured to suppress propagation of cracks in the bezel area on the at least one insulating layer in the bezel area.

In one or more embodiments, the method for manufacturing a display device further comprises covering the at least one insulating layer (e.g., inorganic insulating layer) with a passivation layer having one or more openings (or opening regions).

In one or more embodiments, the step of stacking the at least one insulating layer (e.g., inorganic insulating layer) comprises forming a first buffer layer on the substrate, forming a second buffer layer on the first buffer layer, forming a gate insulating layer on a semiconductor layer on the second buffer layer, forming a first interlayer dielectric layer on a first gate electrode on the gate insulating layer, and forming a second interlayer dielectric layer on a second gate electrode on the first interlayer dielectric layer.

In one or more embodiments, the step of forming the via hole comprises, etching at least one of the second buffer layer, the gate insulating layer, the first interlayer dielectric layer and the second interlayer dielectric layer to form the via hole exposing the first buffer layer of the bezel area.

In one or more embodiments, the method for manufacturing a display device further comprises etching at least one of the second buffer layer, the gate insulating layer, the first interlayer dielectric layer, and the second interlayer dielectric layer of the display area to form contact holes exposing the semiconductor layer, and the second gate electrode.

In one or more embodiments, the method for manufacturing a display device further comprises etching the passivation layer to form the one or more openings (or opening regions) in the passivation layer.

In another aspect, there is provided an apparatus comprising a substrate having a display area and a non-display area, and a crack prevention pattern formed in said non-display area and surrounding said display area, said crack prevention pattern comprising one or more discontinuous portions in one or more insulation layers at said non-display area.

In one or more embodiments, said discontinuous portions consist of walls and gaps in said one or more insulation layers at said non-display area.

In one or more embodiments, the apparatus further comprises a passivation layer covering said one or more walls and filled within said gaps, and said passivation layer has one or more openings that are non-overlapping with said gaps of said crack prevention pattern.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a schematic block diagram of an organic light emitting diode (OLED) display;
FIG. 2 illustrates a first example of a circuit configuration of a subpixel;
FIG. 3 illustrates a second example of a circuit configuration of a subpixel;
FIG. 4 is a plan view of an OLED display;
FIG. 5 is a cross-sectional view of a subpixel of an OLED display;
FIG. 6 is a plan view of a mother substrate of an OLED display;
FIG. 7 is a cross-sectional view taken along line I-I' of FIG. 6;
FIG. 8 is a cross-sectional view of a bezel area of an OLED display taken along II-II' of FIG. 4;
FIG. 9 is a plan view of an OLED display;
FIGS. 10 and 11 are cross-sectional views of a bezel area of an OLED display taken along II-II' of FIG. 4;
FIG. 12 is a cross-sectional view of a bezel area of an OLED display according to a second embodiment of the invention; and
FIGS. 13 to 18 are cross-sectional views sequentially illustrating each of stages in a method for manufacturing an OLED display according to an embodiment of the invention.

### DETAILED DESCRIPTION OF THE EMBODIMENTS

Reference will now be made in detail to embodiments of the invention, examples of which are illustrated in the accompanying drawings. Wherever possible, the same reference numbers will be used throughout the drawings to refer to the same or like parts. It will be paid attention that detailed description of known arts will be omitted if it is determined that the arts can mislead the embodiments of the invention.

A display device according to an embodiment of the invention is a display device, in which a display element is formed on a flexible substrate. Examples of the display device include an organic light emitting diode (OLED) display, a liquid crystal display (LCD), and an electrophoresis display. Embodiments of the invention are described using the OLED display as an example of the display device. The OLED display includes a light emitting layer that is formed of an organic material, between a first electrode serving as an anode and a second electrode serving as a cathode. The OLED display is a self-emission display device configured to form hole-electron pairs, excitons, by combining holes received from the first electrode and electrons received from the second electrode inside the light emitting layer and emit light by energy generated when the excitons return to a ground level. The OLED display according to the embodiment of the invention may use a glass substrate as well as the plastic substrate.

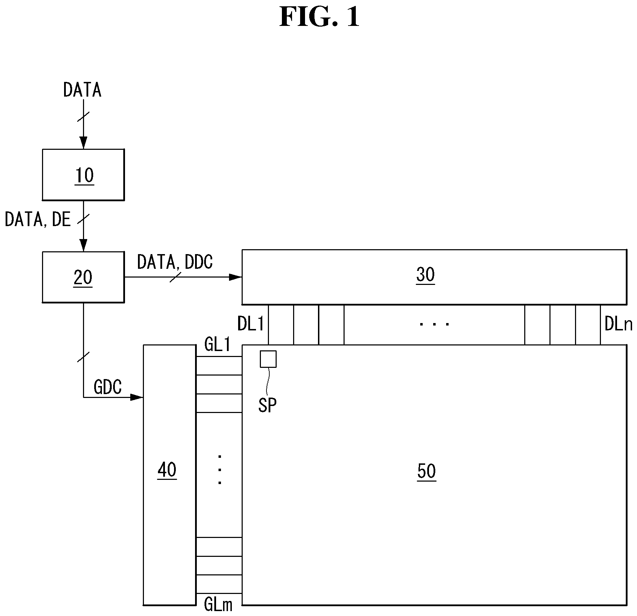

Embodiments of the invention are described below with reference to FIGS. 1 to 18.

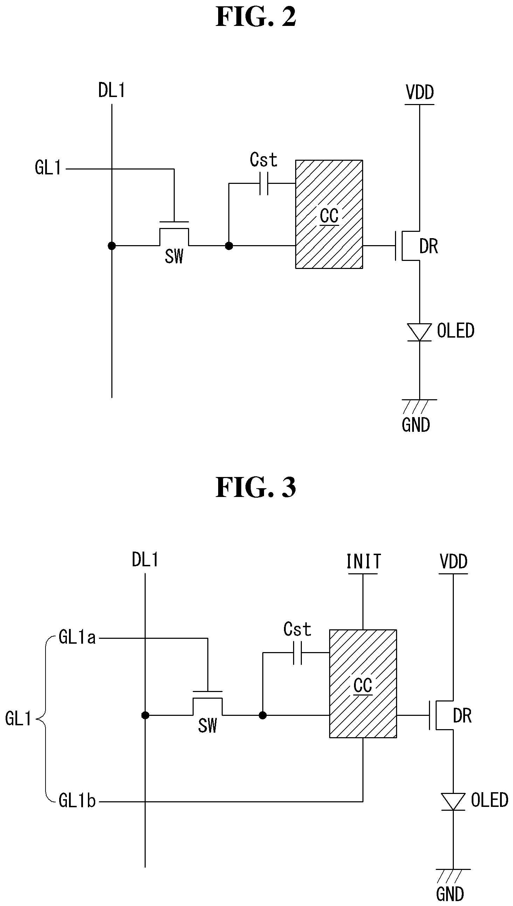

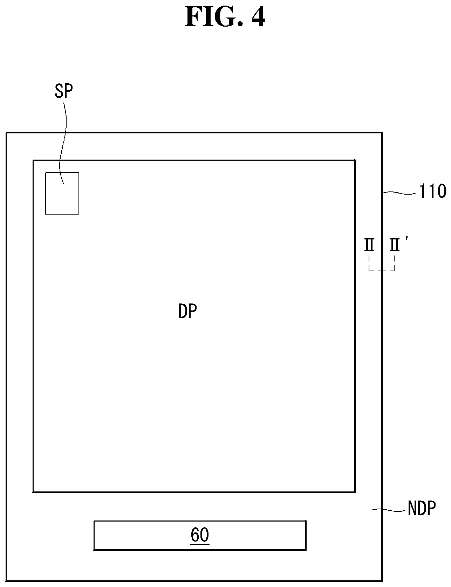

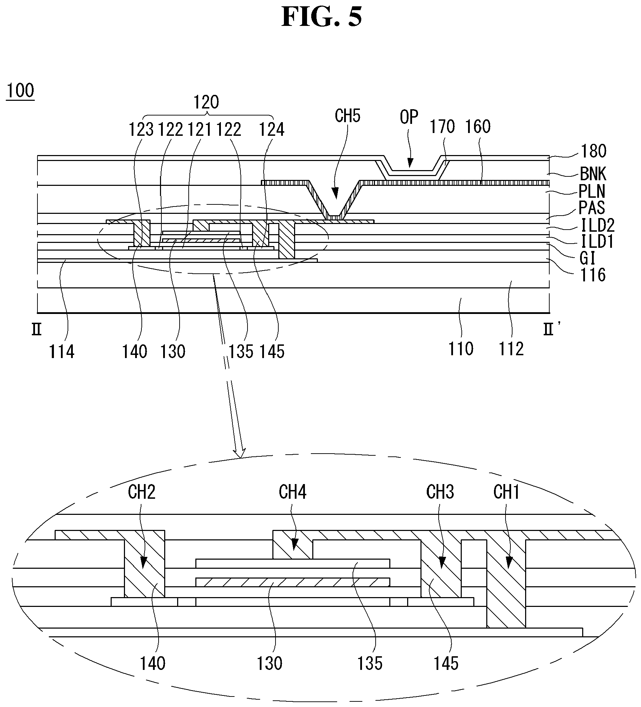

FIG. 1 is a schematic block diagram of an organic light emitting diode (OLED) display. FIG. 2 illustrates a first example of a circuit configuration of a subpixel. FIG. 3 illustrates a second example of a circuit configuration of a subpixel. FIG. 4 is a plan view of an OLED display. FIG. 5 is a cross-sectional view of a subpixel of an OLED display.

Referring to FIG. 1, an OLED display includes an image processing unit 10, a timing controller 20, a data driver 30, a gate driver 40, and a display panel 50.

The image processing unit 10 outputs a data signal DATA and a data enable signal DE supplied from the outside. The image processing unit 10 may output one or more of a vertical sync signal, a horizontal sync signal, and a clock signal in addition to the data enable signal DE. However, the signals are not shown for the sake of brevity and ease of reading. The image processing unit 10 is formed on a system circuit board in an integrated circuit (IC) form.

The timing controller 20 receives the data signal DATA and a driving signal including the data enable signal DE or the vertical sync signal, the horizontal sync signal, the clock signal, etc. from the image processing unit 10.

The timing controller 20 outputs a gate timing control signal GDC for controlling operation timing of the gate driver 40 and a data timing control signal DDC for controlling operation timing of the data driver 30 based on the driving signal. The timing controller 20 is formed on a control circuit board in an integrated circuit (IC) form.

The data driver 30 samples and latches the data signal DATA received from the timing controller 20 in response to the data timing control signal DDC supplied from the timing controller 20 and converts the sampled and latched data signal DATA into a gamma reference voltage. The data driver 30 then outputs the gamma reference voltage. The data driver 30 outputs the data signal DATA through data lines DL1 to DLn. The data driver 30 is attached to a board in an IC form.

The gate driver 40 outputs a gate signal while shifting a level of a gate voltage in response to the gate timing control signal GDC supplied from the timing controller 20. The gate driver 40 outputs the gate signal through gate lines GL1 to GLm. The gate driver 40 is formed on a gate circuit board in an IC form or is formed on the display panel 50 in a gate-in panel (GIP) manner.

The display panel 50 displays an image in response to the data signal DATA and the gate signal respectively received from the data driver 30 and the gate driver 40. The display panel 50 includes subpixels SP displaying the image.

Referring to FIG. 2, each subpixel includes a switching transistor SW, a driving transistor DR, a capacitor Cst, a compensation circuit CC, and an organic light emitting diode (OLED). The OLED operates to emit light based on a driving current generated by the driving transistor DR.

The switching transistor SW performs a switching operation so that a data signal supplied through a first data line DL1 is stored in the capacitor Cst as a data voltage in response to a gate signal supplied through a first gate line GL1. The driving transistor DR operates so that the driving current flows between a high potential power line VDD and a low potential power line GND based on the data voltage stored in the capacitor Cst. The compensation circuit CC is a circuit for compensating for a threshold voltage of the driving transistor DR. The capacitor Cst connected to the switching transistor SW or the driving transistor DR may be mounted inside the compensation circuit CC.

The compensation circuit CC includes one or more thin film transistors (TFTs) and a capacitor. Configuration of the compensation circuit CC may be variously changed depending on a compensation method. A detailed description thereof may be briefly made or may be entirely omitted.

As shown in FIG. 3, the subpixel including the compensation circuit CC further includes a signal line and a power line for driving a compensation TFT and supplying a predetermined signal or electric power. The added signal line may be defined as a 1-2 gate line GL1b for driving the compensation TFT included in the subpixel. The added power line may be defined as an initialization power line INIT for initializing a predetermined node of the subpixel at a predetermined voltage. However, this is merely an example, and the embodiment of the invention is not limited thereto. In FIG. 3, "GLla" is a 1-1 gate line for driving the switching transistor SW.

FIGS. 2 and 3 illustrate that one subpixel includes the compensation circuit CC, as an example. However, the compensation circuit CC may be omitted when an object (for example, the data driver 30) to be compensated is positioned outside the subpixel. The subpixel basically has a configuration of 2T(Transistor)1C(Capacitor) including the switching transistor SW, the driving transistor DR, the capacitor, and the OLED. However, when the compensation circuit CC is added to the subpixel, the subpixel may have various configurations of 3T1C, 4T2C, 5T2C, 6T2C, 7T2C, and the like.

FIGS. 2 and 3 illustrate that the compensation circuit CC is positioned between the switching transistor SW and the driving transistor DR, as an example. However, the compensation circuit CC may be further positioned between the driving transistor DR and the OLED. The position and the structure of the compensation circuit CC are not limited to FIGS. 2 and 3.

Referring to FIG. 4, a display panel of an OLED display includes a substrate 110, a display area DP, and a non-display area NDP. A plurality of subpixels SP is disposed in the display area DP. Red (R), green (G), and blue (B) subpixels or red (R), green (G), blue (B) and white (W) subpixels in the display area DP emit light and implement fill color. The non-display area NDP occupies a remaining area except the display area DP from the substrate 110. A plurality of signal lines is disposed around the display area DP, and a data driver 60 is positioned on one side of the display area DP.

A cross-sectional structure of a subpixel SP of an OLED display 100 according to an embodiment of the invention is described below with reference to FIG. 5.

Referring to FIG. 5, in the OLED display 100 according to the embodiment of the invention, a first buffer layer 112 is positioned on a substrate 110. The substrate 110 is made of glass, plastic, or metal, etc. In the embodiment of the invention, the substrate 110 may be made of plastic, and more particularly, may be a polyimide substrate. Thus, the substrate 110 according to the embodiment of the invention has flexible characteristics. The first buffer layer 112 protects a TFT formed in a subsequent process from impurities, for example, alkali ions discharged from the substrate 110. The first buffer layer 112 may be a silicon oxide (SiOx) layer, a silicon nitride (SiNx) layer, or a multilayer thereof.

A shield layer 114 is positioned on the first buffer layer 112. The shield layer 114 prevents a reduction in a panel driving current which may be generated by using the polyimide substrate 110. A second buffer layer 116 is positioned on the shield layer 114. The second buffer layer 116 protects a TFT formed in a subsequent process from impurities, for example, alkali ions discharged from the shield layer 114. The second buffer layer 116 may be a silicon oxide (SiOx) layer, a silicon nitride (SiNx) layer, or a multilayer thereof.

A semiconductor layer 120 is positioned on the second buffer layer 116. The semiconductor layer 120 may be formed of a silicon semiconductor or an oxide semiconductor. The silicon semiconductor may include amorphous silicon or crystallized polycrystalline silicon. The polycrystalline silicon has a high mobility (for example, 100 cm²/Vs or more), low energy power consumption, and excellent reliability, and thus may be applied to a gate driver and/or a multiplexer (MUX) for use in a driving element or applied to a driving TFT of each pixel of the OLED display 100. Because the oxide semiconductor has a low off-current, the oxide semiconductor is suitable for a switching TFT which has a short on-time and a long off-time. Further, because the oxide semiconductor increases a voltage hold time of the pixel due to the low off-current, the oxide semiconductor is suitable for a display device requiring a slow driving and/or low power consumption. The semiconductor layer 120 includes a drain region 123 and a source region 124 each including p-type or n-type impurities and a channel 121 between the drain region 123 and the source region 124. The semiconductor layer 120 further includes a lightly doped region 122 between the drain region 123 and the source region 124 adjacent to the channel 121.

A gate insulating layer GI is positioned on the semiconductor layer 120. The gate insulating layer GI may be a silicon oxide (SiOx) layer, a silicon nitride (SiNx) layer, or a multilayer thereof. A first gate electrode 130 is positioned on the gate insulating layer GI in a predetermined region of the semiconductor layer 120, namely, at a location corresponding to the channel 121 when impurities are injected. The first gate electrode 130 serves as a gate electrode of a driving transistor DR. The first gate electrode 130 is formed of one selected from the group consisting of molybdenum (Mo), aluminum (Al), chrome (Cr), gold (Au), titanium (Ti), nickel (Ni), neodymium (Nd), and copper (Cu), or a combination thereof. Further, the first gate electrode 130 may be a multilayer formed of one selected from the group consisting of molybdenum (Mo), aluminum (Al), chrome (Cr), gold (Au), titanium (Ti), nickel (Ni), neodymium (Nd), and copper (Cu), or a combination thereof. For example, the first gate electrode 130 may be formed as a double layer of Mo/Al-Nd or Mo/Al.

A first interlayer dielectric layer ILD1 is positioned on the first gate electrode 130 to insulate the first gate electrode 130. The first interlayer dielectric layer ILD1 may be a silicon oxide (SiOx) layer, a silicon nitride (SiNx) layer, or a multilayer thereof. A second gate electrode 135 is positioned on the first interlayer dielectric layer ILD1. The second gate electrode 135 is a capacitor electrode forming a capacitor together with the first gate electrode 130 and does not serve as a gate electrode of the driving transistor DR. A second interlayer dielectric layer ILD2 is positioned on the second gate electrode 135 to insulate the second gate electrode 135.

A first contact hole CH1 is positioned in a portion of each of the second interlayer dielectric layer ILD2, the first interlayer dielectric layer ILD1, the gate insulating layer GI, and the second buffer layer 116 to expose a portion of the shield layer 114. Second and third contact holes CH2 and CH3 are positioned in a portion of each of the second interlayer dielectric layer ILD2, the first interlayer dielectric layer ILD1, and the gate insulating layer GI to expose a portion of the semiconductor layer 120. More specifically, the second contact hole CH2 exposes the drain region 123 of the semiconductor layer 120, and the third contact hole CH3 exposes the source region 124 of the semiconductor layer 120. A fourth contact hole CH4 is positioned in a portion of the second interlayer dielectric layer ILD2 to expose the second gate electrode 135.

A drain electrode 140 and a source electrode 145 are positioned on the second interlayer dielectric layer ILD2. The drain electrode 140 is connected to the semiconductor layer 120 through the second contact hole CH2 exposing the drain region 123 of the semiconductor layer 120. The source electrode 145 is connected to the semiconductor layer 120 through the third contact hole CH3 exposing the source region 124 of the semiconductor layer 120. Further, the source electrode 145 is connected to the shield layer 114 through the first contact hole CH1 that passes through the second interlayer dielectric layer ILD2, the first interlayer dielectric layer ILD1, the gate insulating layer GI, and the second buffer layer 116 and exposes the shield layer 114. The source electrode 145 is connected to the second gate electrode 135 through the fourth contact hole CH4. Each of the drain electrode 140 and the source electrode 145 may be formed as a single layer or a multilayer. When each of the drain electrode 140 and the source electrode 145 is formed as the single layer, each of the drain electrode 140 and the source electrode 145 may be formed of one selected from the group consisting of molybdenum (Mo), aluminum (Al), chrome (Cr), gold (Au), titanium (Ti), nickel (Ni), neodymium (Nd), and copper (Cu), or a combination thereof. When each of the drain electrode 140 and the source electrode 145 is formed as the multilayer, each of the drain electrode 140 and the source electrode 145 may be formed as a double layer of Mo/Al-Nd or a triple layer of Ti/Al/Ti, Mo/Al/Mo or Mo/Al-Nd/Mo.

Thus, the driving transistor DR including the semiconductor layer 120, the first gate electrode 130, the drain electrode 140, and the source electrode 145 is formed.

A passivation layer PAS is positioned on the substrate 110 including the driving transistor DR. The passivation layer PAS is an insulating layer protecting an element underlying the passivation layer PAS. The passivation layer PAS may be a silicon oxide (SiOx) layer, a silicon nitride (SiNx) layer, or a multilayer thereof. A planarization layer PLN is positioned on the passivation layer PAS. The planarization layer PLN may be a planarization layer for reducing a height difference of an underlying structure. The planarization layer PLN may be formed of an organic material such as polyimide, benzocyclobutene-based resin, and acrylate. The planarization layer PLN may be formed through a spin-on glass (SOG) method for coating the organic material in a liquid state and then curing the organic material.

A fifth contact hole CH5 is positioned in a portion of the planarization layer PLN to expose the source electrode 145. A first electrode 160 is positioned on the planarization layer PLN. The first electrode 160 serves as a pixel electrode and is connected to the source electrode 145 of the driving transistor DR through a fifth contact hole CH5. The first electrode 160 is an anode and may be formed of a transparent conductive material such as indium tin oxide (ITO), indium zinc oxide (IZO), and zinc oxide (ZnO). When the first electrode 160 is a reflective electrode, the first electrode 160 further includes a reflective layer. The reflective layer may be formed of aluminum (Al), copper (Cu), silver (Ag), nickel (Ni), Pd (palladium) or a combination thereof. The reflective layer may be formed of Ag/Pd/Cu (APC) alloy.

A bank layer BNK is positioned on the substrate 110 including the first electrode 160 to divide the pixel. The bank layer BNK may be formed of an organic material such as polyimide, benzocyclobutene-based resin, and acrylate. The bank layer BNK includes a pixel definition portion OP exposing the first electrode 160. A light emitting layer 170 contacting the first electrode 160 is positioned on the pixel definition portion OP of the bank layer BNK. The light emitting layer 170 is a layer, in which electrons and holes combine and emit light. A hole injection layer or a hole transport layer may be positioned between the light emitting layer 170 and the first electrode 160, and an electron injection layer or an electron transport layer may be positioned on the light emitting layer 170.

A second electrode 180 is positioned on the light emitting layer 170. The second electrode 180 is positioned on a front surface of the substrate 110. The second electrode 180 is a cathode electrode and may be formed of magnesium (Mg), calcium (Ca), aluminum (Al), silver (Ag), or a combination thereof each having a low work function. When the second electrode 180 is a transmissive electrode, the second electrode 180 is thin enough to transmit light. When the second electrode 180 is a reflective electrode, the second electrode 180 is thick enough to reflect light.

The OLED display according to the embodiment of the invention has a problem of device degradation as cracks generated in inorganic layers in a scribing process serve as a moisture penetration path.

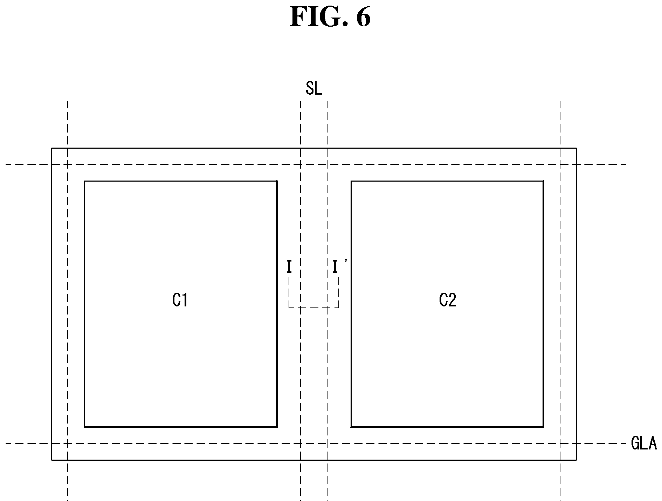

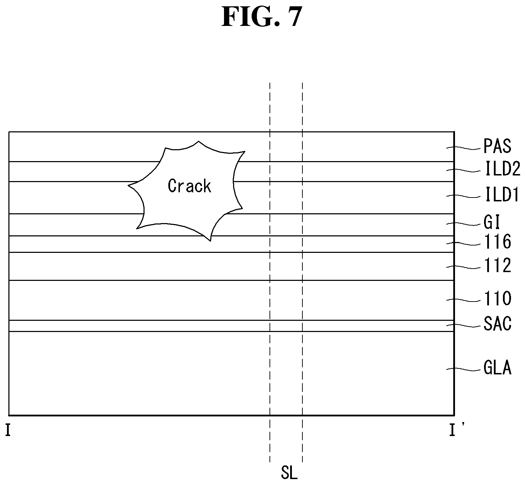

FIG. 6 is a plan view of a mother substrate of an OLED display. FIG. 7 is a cross-sectional view taken along line I-I' of FIG. 6.

Referring to FIG. 6, a first cell C1 and a second cell C2 are formed on a mother substrate GLA. FIG. 6 shows only two cells for the sake of brevity and ease of reading. However, a plurality of cells may be formed on the mother substrate GLA. The mother substrate GLA, on which the first cell C1 and the second cell C2 are formed, is scribed along a scribing line SL, and thus the first and second cells C1 and C2 are separated from each other. Each of the separated first and second cells C1 and C2 is formed as an OLED display.

Referring to FIG. 7, a plurality of layers is stacked on the scribing line SL of the mother substrate GLA. For example, a sacrifice layer SAC is positioned on the mother substrate GLA, a substrate 110 is positioned on the sacrifice layer SAC, and a first buffer layer 112 and a second buffer layer 116 are positioned on the substrate 110. Further, a gate insulating layer GI, a first interlayer dielectric layer ILD1, and a second interlayer dielectric layer ILD2 are positioned on the second buffer layer 116, and a passivation layer PAS is positioned on the second interlayer dielectric layer ILD2.

The layers, for example, the first buffer layer 112, the second buffer layer 116, the gate insulating layer GI, the first interlayer dielectric layer ILD1, the second interlayer dielectric layer ILD2, and the passivation layer PAS disposed on the scribing line SL of the mother substrate GLA are formed as inorganic insulating layers. Thus, cracks may be generated in the inorganic insulating layers by a cutting wheel or a laser used in the scribing process for the cell separation.

Thus, the embodiment of the invention can prevent the cracks from serving as the moisture penetration path even if the cracks are generated and propagated in the inorganic insulating layers.

### <First Embodiment>

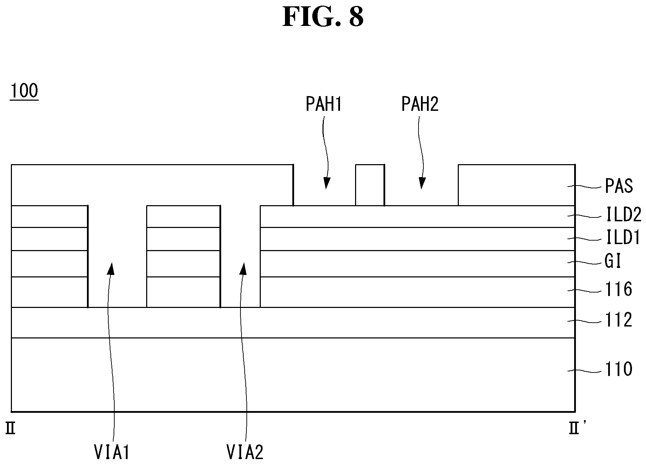

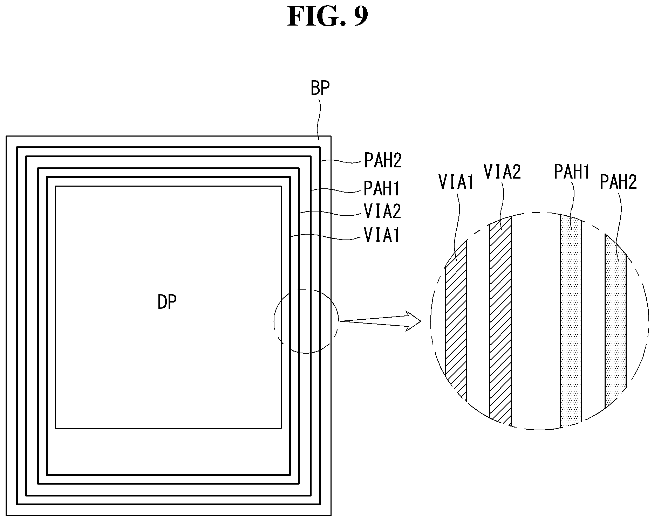

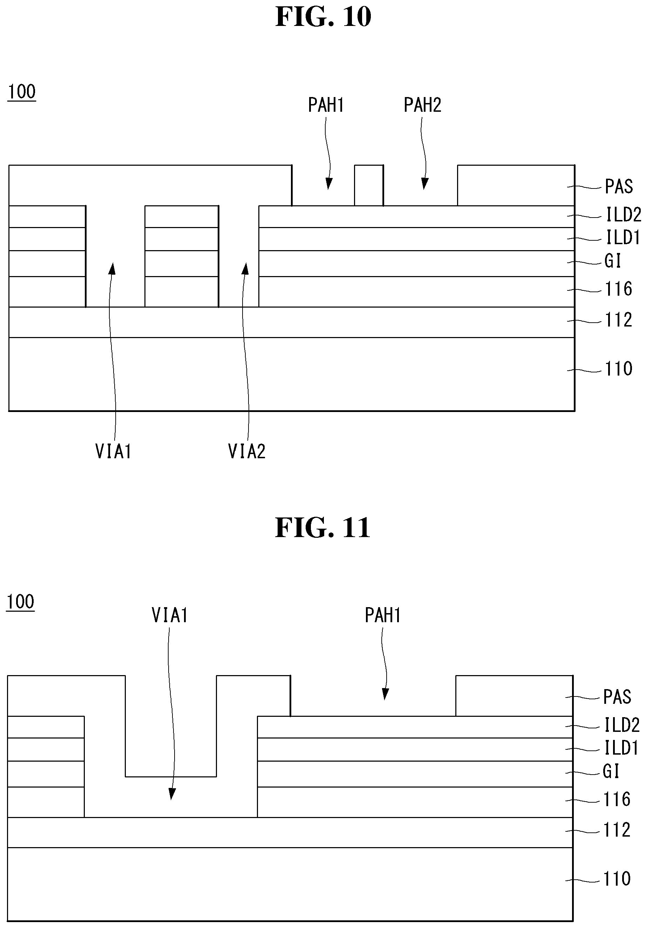

FIG. 8 is a cross-sectional view of a bezel area of an OLED display taken along II-II' of FIG. 4. FIG. 9 is a plan view of an OLED display. FIGS. 10 and 11 are cross-sectional views of a bezel area of an OLED display taken along II-II' of FIG. 4.

Referring to FIG. 8, in an OLED display 100 according to an embodiment of the invention, a first buffer layer 112 is positioned on a substrate 110, and a second buffer layer 116 is positioned on the first buffer layer 112. A gate insulating layer GI is positioned on the second buffer layer 116, and a first interlayer dielectric layer ILD1 and a second interlayer dielectric layer ILD2 are sequentially positioned on the gate insulating layer GI.

A passivation layer PAS is positioned on the second interlayer dielectric layer ILD2. The passivation layer PAS according to the embodiment of the invention contacts the first buffer layer 112 through at least one via hole. More specifically, the passivation layer PAS contacts the first buffer layer 112 through first and second via holes VIA1 and VIA2 formed by penetrating the second buffer layer 116, the gate insulating layer GI, the first interlayer dielectric layer ILD1, and the second interlayer dielectric layer ILD2. The first and second via holes VIA1 and VIA2 are through holes formed by successively penetrating the second buffer layer 116, the gate insulating layer GI, the first interlayer dielectric layer ILD1, and the second interlayer dielectric layer ILD2 and cause the passivation layer PAS to contact the first buffer layer 112.

The passivation layer PAS contacting the first buffer layer 112 through the first and second via holes VIA1 and VIA2 serves as a barrier that suppresses moisture penetration when cracks are generated in the second buffer layer 116, the gate insulating layer GI, the first interlayer dielectric layer ILD1, and/or the second interlayer dielectric layer ILD2. The embodiment of the invention illustrated and described a total of two via holes VIA1 and VIA2, but is not limited thereto. For example, one or more via holes may be used, and a plurality of via holes may be used as long as the size of the bezel area is kept minimal.

The passivation layer PAS according to the embodiment of the invention includes at least one opening adjacent to a bezel area BP of the substrate 110. Because the passivation layer PAS is positioned on a front surface of the substrate 110, the passivation layer PAS may create a penetration path of moisture when a crack is generated in the passivation layer PAS. Thus, the embodiments of the invention employ openings, gaps, or a discontinuous pattern for blocking, separating or cutting off the continuous formation of the passivation layer PAS, in order to inhibit the passivation layer PAS from creating undesirable moisture penetration paths.

More specifically, the passivation layer PAS includes a first opening (or gap) PAH1 and a second opening (or gap) PAH2. The first opening PAH1 and the second opening PAH2 are formed by partially removing the passivation layer PAS and expose the second interlayer dielectric layer ILD2 under the passivation layer PAS. The first opening PAH1 and the second opening PAH2 may have a loop shape from a planar perspective such that the display area DP is surrounded. FIG. 8 shows the first and second openings PAH1 and PAH2 of a rectangular loop shape, as an example. The first and second openings PAH1 and PAH2 may have various shapes including a circle, an oval, etc. depending on a shape of a display area DP. The embodiment of the invention illustrated and described a total of two openings PAH1 and PAH2, but is not limited thereto. For example, one or more openings may be used, and a plurality of openings may be used as long as the size of the bezel area is considered.

Referring to FIG. 9, the first and second via holes VIA1 and VIA2 according to the embodiment of the invention each have a planar loop shape surrounding the display area DP. Thus, the passivation layer PAS filled in the first and second via holes VIA1 and VIA2 can block moisture penetrating from an edge of the display device. Further, the first and second openings PAH1 and PAH2 according to the embodiment of the invention each have an encompassing shape surrounding most or all of the display area DP. Thus, the first and second openings PAH1 and PAH2 can effectively block moisture penetrating from the edge of the display device along the crack of the passivation layer PAS. The via holes (VIA1 and VIA2) may be positioned to be separated from the openings (PAH1 and PAH2). That is, the via holes (VIA1 and VIA2) may not be overlapped with the openings (PAH1 and PAH2) in a vertical direction.

Referring to FIG. 10, the first and second via holes (or gaps) VIA1 and VIA2 according to the embodiment of the invention may be formed inside the first buffer layer 112 by etching a portion of the first buffer layer 112. The embodiment of the invention can block moisture penetrating along the crack(s) of the second buffer layer 116 by etching the inside of the first buffer layer 112 so that the second buffer layer 116 is fully etched in a process for etching the first and second via holes VIA1 and VIA2.

Referring to FIG. 11, the embodiment of the invention may include one via hole VIA1 and one openings PAH1. The embodiment of the invention can improve a blocking effect of a penetration path of moisture by increasing a size of the via hole VIA1 and/or a size of the opening PAH1

### <Second Embodiment>

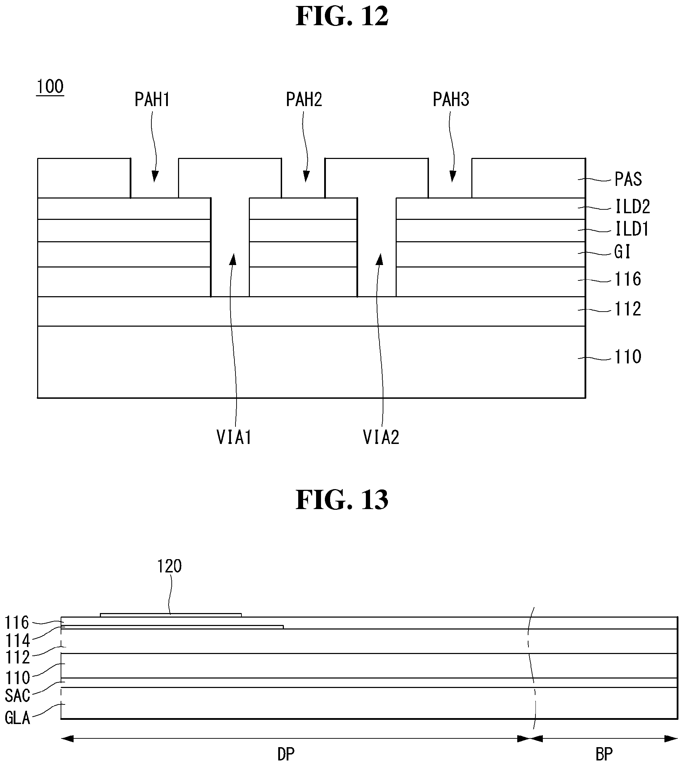

FIG. 12 is a cross-sectional view of a bezel area of an OLED display according to a second embodiment of the invention.

Referring to FIG. 12, a passivation layer PAS is positioned on a second interlayer dielectric layer ILD2. The passivation layer PAS according to the embodiment of the invention contacts a first buffer layer 112 through first and second via holes VIA1 and VIA2 formed by penetrating a second buffer layer 116, a gate insulating layer GI, a first interlayer dielectric layer ILD1, and the second interlayer dielectric layer ILD2. The passivation layer PAS according to the embodiment of the invention may include three openings including a first opening PAH1, a second opening PAH2, and a third opening PAH3, that are formed by partially removing the passivation layer PAS and expose the second interlayer dielectric layer ILD2 under the passivation layer PAS.

In the second embodiment of the invention, the via holes and the openings may be alternately positioned. More specifically, the first via hole VIA1 may be positioned adjacent to the first opening PAH1, the second opening PAH2 may be positioned adjacent to the first via hole VIA1, the second via hole VIA2 may be positioned adjacent to the second opening PAH2, and the third opening PAH3 may be positioned adjacent to the second via hole VIA2.

The alternating structure of the first to third openings PAH1 to PAH3 and the first and second via holes VIA1 and VIA2 can prevent an increase in the size of the bezel area by forming the via hole between process margins of the openings.

The embodiment of the invention illustrated and described the alternating structure of the three openings PAH1, PAH2, and PAH3 and the two via holes VIA1 and VIA2, but is not limited thereto. For example, two openings and one via hole may be alternately disposed, or two via holes and one opening may be alternately disposed.

A method for manufacturing an OLED display according to an embodiment of the invention is described below.

FIGS. 13 to 18 are cross-sectional views sequentially illustrating each of stages in a method for manufacturing an OLED display according to an embodiment of the invention.

Referring to FIG. 13, a sacrifice layer SAC is positioned on a mother substrate GLA. The mother substrate GLA is made of glass and function to support structures on the mother substrate GLA. The sacrifice layer SAC expands by heat and allows a plastic substrate to be released from the mother substrate GLA.

Polyimide may be coated on the sacrifice layer SAC to form a substrate 110. A first buffer layer 112 is formed on the substrate 110. An opaque material is stacked on the first buffer layer 112 and is patterned using a first mask to form a shield layer 114. Subsequently, a second buffer layer 116 is formed on the substrate 110, on which the shield layer 114 is formed. A silicon semiconductor or an oxide semiconductor is stacked on the second buffer layer 116 and is patterned using a second mask to form a semiconductor layer 120.

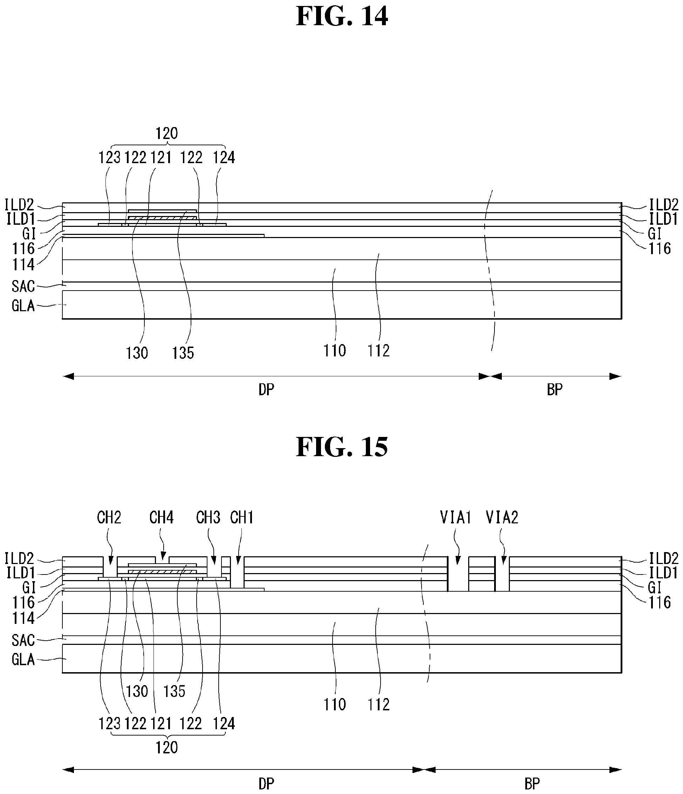

Next, referring to FIG. 14, a gate insulating layer GI is formed on semiconductor layer 120. A metal material is stacked on the gate insulating layer GI and is patterned using a third mask to form a first gate electrode 130. Subsequently, n-type impurities are lightly doped on a front surface of the substrate 110 to dope the semiconductor layer 120. In this instance, a remaining portion of the semiconductor layer 120 except a lower part of the first gate electrode 130 is doped using the first gate electrode 130 on the semiconductor layer 120 as a mask.

Next, n-type impurities are heavily doped on the front surface of the substrate 110 to dope the semiconductor layer 120. In this instance, a predetermined region of the semiconductor layer 120 is masked using a fourth mask and doped to form a channel 121, a lightly doped region 122, a drain region 123, and a source region 124 in the semiconductor layer 120.

Subsequently, a first interlayer dielectric layer ILD1 is formed on the first gate electrode 130. A metal material is stacked on the first interlayer dielectric layer ILD1 and is patterned using a fifth mask to form a second gate electrode 135. The first gate electrode 130 and the second gate electrode 135 are formed to overlap each other and may form a capacitance. Subsequently, a second interlayer dielectric layer ILD2 is formed on the substrate 110, on which the second gate electrode 135 is formed.

Next, referring to FIG. 15, a photoresist is applied to the second interlayer dielectric layer ILD2 and dry etches the second interlayer dielectric layer ILD2, the first interlayer dielectric layer ILD1, the gate insulating layer GI, and the second buffer layer 116 using a sixth mask. More specifically, the second interlayer dielectric layer ILD2, the first interlayer dielectric layer ILD1, the gate insulating layer GI, and the second buffer layer 116 are etched to form a first contact hole CH1 exposing the shield layer 114. At the same time, the second interlayer dielectric layer ILD2, the first interlayer dielectric layer ILD1, and the gate insulating layer GI are etched to form a second contact hole CH2 exposing the drain region 123 of the semiconductor layer 120 and a third contact hole CH3 exposing the source region 124 of the semiconductor layer 120. At the same time, the second interlayer dielectric layer ILD2 is etched to form a fourth contact hole CH4 exposing the second gate electrode 135.

Further, at the same time as the above dry etching, the second interlayer dielectric layer ILD2, the first interlayer dielectric layer ILD1, the gate insulating layer GI, and the second buffer layer 116 in a bezel area BP are etched to form a first via hole VIA1 and a second via hole VIA2.

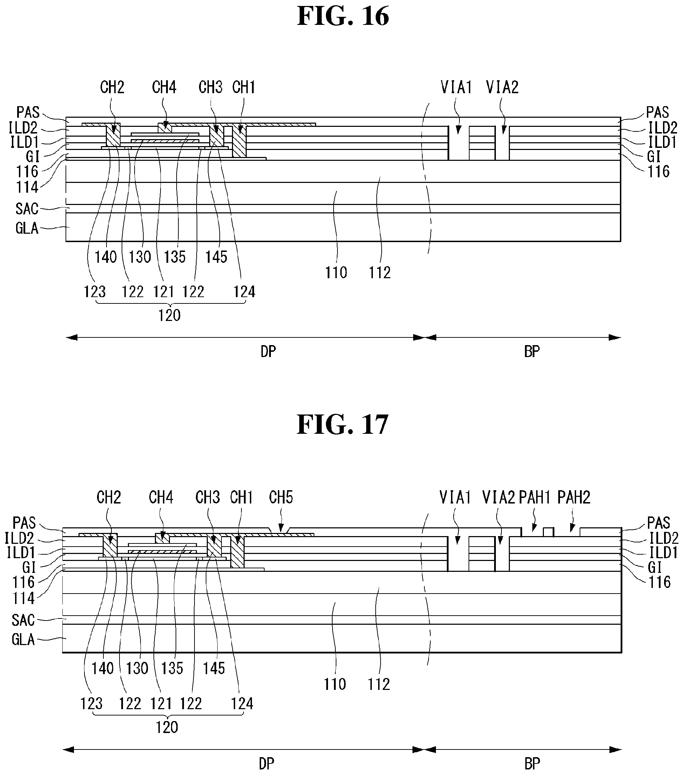

Next, referring to FIG. 16, a metal material is stacked on the substrate 110, on which the second interlayer dielectric layer ILD2 is formed, and is patterned using a seventh mask to form a drain electrode 140 and a source electrode 145. The drain electrode 140 is connected to the drain region 123 of the semiconductor layer 120 through the second contact hole CH2, and the source electrode 145 is connected to the source region 124 of the semiconductor layer 120 through the third contact hole CH3. Further, the source electrode 145 is connected to the shield layer 114 through the first contact hole CH1 and is connected to the second gate electrode 135 through the fourth contact hole CH4. Thus, a driving transistor including the semiconductor layer 120, the first gate electrode 130, the drain electrode 140, and the source electrode 145 is formed.

Subsequently, a passivation layer PAS is formed on the front surface of the substrate 110. The passivation layer PAS entirely covers a display area DP and entirely covers the bezel area BP while being filled in the first and second via holes VIA1 and VIA2 in the bezel area BP. The passivation layer PAS contacts the first buffer layer 112 through the first and second via holes VIA1 and VIA2 in the bezel area BP.

Next, referring to FIG. 17, a portion of the passivation layer PAS is etched using an eighth mask to form a fifth contact hole CH5 exposing the source electrode 145 in the display area DP and form a first opening PAH1 and a second opening PAH2 in the bezel area BP.

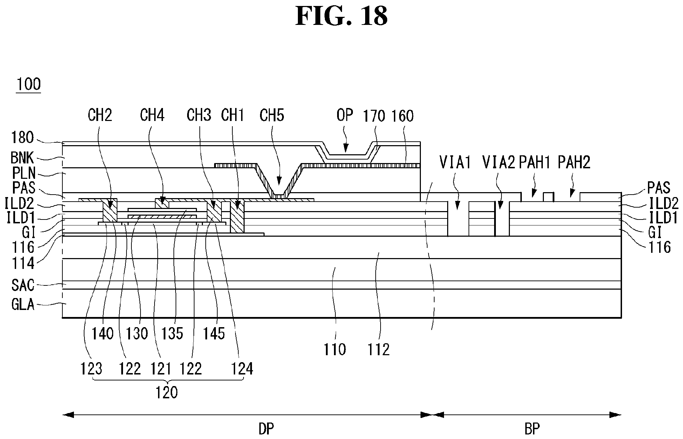

Next, referring to FIG. 18, an organic material is applied to the front surface of the substrate 110 to form a planarization layer PLN. An etching process is performed on the planarization layer PLN using a ninth mask to extend the fifth contact hole CH5 of the passivation layer PAS and remove the planarization layer PLN of the bezel area BP. Subsequently, a transparent conductive layer is stacked on the planarization layer PLN and is patterned using a tenth mask to form a first electrode 160. The first electrode 160 may be connected to the source electrode 145 of the driving transistor through the fifth contact hole CH5. Subsequently, a bank layer BNK is formed on the substrate 110 including the first electrode 160. The bank layer BNK is a pixel definition layer that exposes a portion of the first electrode 160 and defines a pixel. The bank layer BNK may be formed of an organic material such as polyimide, benzocyclobutene-based resin, and acrylate. The bank layer BNK includes a pixel definition portion OP exposing the first electrode 160 using an eleventh mask. Subsequently, a light emitting layer 170 is formed on the first electrode 160 exposed by the pixel definition portion OP of the bank layer BNK. A second electrode 180 is formed on the substrate 110, on which the light emitting layer 170 is formed. Thus, the OLED display according to the embodiment of the invention is manufactured using a total of eleven masks.

As described above, the OLED display according to the embodiment of the invention forms the first and second via holes in the bezel area through the dry etching process for forming the first to fourth contact holes in the display area at once, thereby blocking the penetration path of moisture due to the passivation layer filled in the first and second via holes. Furthermore, the OLED display according to the embodiment of the invention forms the first and second openings in the passivation layer, thereby blocking the penetration path of moisture penetrating along any cracks of the passivation layer. Thus, the OLED display according to the embodiment of the invention can prevent a reduction in lifespan by preventing the deterioration of the organic material of the light emitting layer resulting from the moisture penetration and can improve the reliability.

## Claims

1. A display device (100) comprising:
a substrate (110) including a display area (DP) having a plurality of subpixels (SP) and a bezel area (BP) around the display area (DP);
a plurality of insulating layers (116, GI, ILD1, ILD2) sequentially disposed on the display area and the bezel area of the substrate (110), wherein the plurality of insulating layers (116, GI, ILD1, ILD2) includes a second buffer layer (116), a gate insulating layer (GI), a first interlayer dielectric layer (ILD1), and a second interlayer dielectric layer (ILD2);
at least one via hole (VIA1, VIA2) passing through the plurality of insulating layers in the bezel area, wherein the via hole (VIA1, VIA2) passes through the second buffer layer (116), the gate insulating layer (GI), the first interlayer dielectric layer (ILD1), and the second interlayer dielectric layer (ILD2);
a passivation layer (PAS) positioned on the second interlayer dielectric layer (ILD2), wherein the passivation layer (PAS) contacts a first buffer layer (112) formed under the plurality of insulating layers through the via hole (VIA1, VIA2); and
at least one opening (PAH1, PAH2) passing through the passivation layer (PAS) on the plurality of insulating layers (116, GI, ILD1, ILD2) in the bezel area,
wherein the via hole (VIA1, VIA2) and the at least one opening (PAH1, PAH2) each surround the display area (DP) to form a respective closed loop,
wherein the at least one via hole (VIA1, VIA2) and the at least one opening (PAH1, PAH2) are configured to suppress propagation of cracks in the bezel area (BP), and
wherein the via hole (VIA1, VIA2) is further configured to block moisture penetration through the cracks.

2. The display device (100) of claim 1, wherein the opening (PAH1, PAH2) is separated from the via hole (VIA1, VIA2) to be positioned outside the via hole (VIA1, VIA2).

3. The display device (100) of claim 1 or 2, wherein the opening (PAH1, PAH2) surrounds the display area (DP) and is positioned in parallel with the via hole (VIA1, VIA2).

4. The display device (100) of claim 1, wherein the opening (PAH1, PAH2) and the via hole (VIA1, VIA2) are alternately positioned.

5. The display device (100) of any one of claims 1 to 4, wherein the opening (PAH1, PAH2) and the via hole (VIA1, VIA2) have a loop shape from a planar perspective.

6. A method for manufacturing a display device (100) as recited in claim 1 comprising:
sequentially stacking a plurality of insulating layers (116, GI, ILD1, ILD2) on a substrate (110) having a display area (DP) and a bezel area (BP),
wherein the step of stacking the plurality of insulating layers (116, GI, ILD1, ILD2) comprises
forming a first buffer layer (112) on the substrate (110);
forming a second buffer layer (116) on the first buffer layer (112);
forming a gate insulating layer (GI) on a semiconductor layer (120) on the second buffer layer (116);
forming a first interlayer dielectric layer (ILD1) on a first gate electrode (130) on the gate insulating layer (GI); and
forming a second interlayer dielectric layer (ILD2) on a second gate electrode (135) on the first interlayer dielectric layer (ILD1);
forming at least one via hole (VIA1, VIA2) configured to suppress propagation of cracks in the bezel area (BP) to pass through the plurality of insulating layers (116, GI, ILD1, ILD2) in the bezel area (BP),
wherein the step of forming the via hole (VIA1, VIA2) comprises:
etching the second buffer layer (116), the gate insulating layer (GI), the first interlayer dielectric layer (ILD1), and the second interlayer dielectric layer (ILD2) to form the via hole (VIA1, VIA2) exposing the first buffer layer (112) in the bezel area (BP);
covering the plurality of insulating layers (116, GI, ILD1, ILD2) with a passivation layer (PAS), wherein the passivation layer (PAS) contacts the first buffer layer (112) through the via hole (VIA1, VIA2); and
etching the passivation layer (PAS) to form at least one opening (PAH1, PAH2) in the passivation layer (PAS),
wherein the via hole (VIA1, VIA2) and the at least one opening (PAH1, PAH2) each are formed as a respective closed loop surrounding the display area (DP),
wherein the via hole (VIA1, VIA2) is further configured to block moisture penetration through the cracks.

7. The method of claim 6, further comprising:
etching the second buffer layer (116), the gate insulating layer (GI), the first interlayer dielectric layer (ILD1), and the second interlayer dielectric layer (ILD2) in the display area (DP) to form contact holes (CH2, CH3, CH4) exposing the semiconductor layer (120), and the second gate electrode (135).

## Patentansprüche

1. Eine Anzeigevorrichtung (100), aufweisend:
ein Substrat (110), das einen Anzeigebereich (DP), der eine Mehrzahl von Sub-Pixeln (SP) aufweist, und einen Umrandungsbereich (BP) um den Anzeigebereich (DP) herum aufweist;
eine Mehrzahl von isolierenden Schichten (116, GI, ILD1, ILD2), die nacheinander auf dem Anzeigebereich und dem Umrandungsbereich des Substrats (110) angeordnet sind, wobei die Mehrzahl von isolierenden Schichten (116, GI, ILD1, ILD2) eine zweite Pufferschicht (116), eine Gate-isolierende Schicht (GI), eine erste Zwischenschicht-Dielektrikumschicht (ILD1) und eine zweite Zwischenschicht-Dielektrikumschicht (ILD2) aufweist;
mindestens ein Durchgangsloch (VIA1, VIA2), das durch die Mehrzahl von isolierenden Schichten in dem Umrandungsbereich hindurchtritt, wobei das Durchgangsloch (VIA1, VIA2) durch die zweite Pufferschicht (116), die Gate-isolierende Schicht (GI), die erste Zwischenschicht-Dielektrikumschicht (ILD1) und die zweite Zwischenschicht-Dielektrikumschicht (ILD2) hindurchtritt;
eine Passivierungsschicht (PAS), die auf der zweiten Zwischenschicht-Dielektrikumschicht (ILD2) angeordnet ist, wobei die Passivierungsschicht (PAS) eine erste Pufferschicht (112), die unter der Mehrzahl von isolierenden Schichten gebildet ist, durch das Durchgangsloch (VIA1, VIA2) hindurch kontaktiert; und
mindestens eine Öffnung (PAH1, PAH2), die durch die Passivierungsschicht (PAS) auf der Mehrzahl von isolierenden Schichten (116, GI, ILD1, ILD2) in dem Umrandungsbereich hindurchtritt,
wobei das Durchgangsloch (VIA1, VIA2) und die mindestens eine Öffnung (PAH1, PAH2) jeweils den Anzeigebereich (DP) derart umgeben, dass sie eine jeweilige geschlossene Schleife bilden,
wobei das mindestens eine Durchgangsloch (VIA1, VIA2) und die mindestens eine Öffnung (PAH1, PAH2) dazu eingerichtet sind, ein Fortschreiten von Sprüngen in dem Umrandungsbereich (BP) zu unterdrücken, und
wobei das Durchgangsloch (VIA1, VIA2) ferner dazu eingerichtet ist, ein Eindringen von Feuchtigkeit durch die Sprünge hindurch zu blockieren.

2. Die Anzeigevorrichtung (100) gemäß Anspruch 1, wobei die Öffnung (PAH1, PAH2) derart von dem Durchgangsloch (VIA1, VIA2) getrennt angeordnet ist, dass sie außerhalb des Durchgangslochs (VIA1, VIA2) angeordnet ist.

3. Die Anzeigevorrichtung (100) gemäß Anspruch 1 oder 2, wobei die Öffnung (PAH1, PAH2) den Anzeigebereich (DP) umgibt und parallel zu dem Durchgangsloch (VIA1, VIA2) angeordnet ist.

4. Die Anzeigevorrichtung (100) gemäß Anspruch 1, wobei die Öffnung (PAH1, PAH2) und das Durchgangsloch (VIA1, VIA2) abwechselnd angeordnet sind.

5. Die Anzeigevorrichtung ((100) gemäß einem der Ansprüche 1 bis 4, wobei die Öffnung (PAH1, PAH2) und das Durchgangsloch (VIA1, VIA2) in einer Draufsicht eine Schleifenform aufweisen.

6. Ein Verfahren zum Herstellen einer Anzeigevorrichtung (100), wie in Anspruch 1 aufgeführt, aufweisend:
nacheinander Stapeln eine Mehrzahl von isolierenden Schichten (116, GI, ILD1, ILD2) auf einem Substrat (110), das einen Anzeigebereich (DP) und einen Umrandungsbereich (BP) aufweist,
wobei der Schritt des Stapelns der Mehrzahl von isolierenden Schichten (116, GI, ILD1, ILD2) aufweist
Bilden einer ersten Pufferschicht (112) auf dem Substrat (110);
Bilden einer zweiten Pufferschicht (116) auf der ersten Pufferschicht (112);
Bilden einer Gate-isolierenden Schicht (GI) auf einer Halbleiterschicht (120) auf der zweiten Pufferschicht (116);
Bilden einer ersten Zwischenschicht-Dielektrikumschicht (ILD1) auf einer ersten Gate-Elektrode (130) auf der Gate-isolierenden Schicht (GI); und
Bilden einer zweiten Zwischenschicht-Dielektrikumschicht (ILD2) auf einer zweiten Gate-Elektrode (135) auf der ersten Zwischenschicht-Dielektrikumschicht (ILD1) ;
Bilden von mindestens einem Durchgangsloch (VIA1, VIA2), das dazu eingerichtet ist, ein Fortschreiten von Sprüngen in dem Umrandungsbereich (BP) daran zu hindern, sich durch die Mehrzahl von isolierenden Schichten (116, GI, ILD1, ILD2) in dem Umrandungsbereich (BP) hindurch fortzusetzen,
wobei der Schritt des Bildens des Durchgangslochs (VIA1, VIA2) aufweist:
Ätzen der zweiten Pufferschicht (116), der Gate-isolierenden Schicht (GI), der ersten Zwischenschicht-Dielektrikumschicht (ILD1) und der zweiten Zwischenschicht-Dielektrikumschicht (ILD2) zum Bilden des Durchgangslochs, das die erste Pufferschicht (112) in dem Umrandungsbereich (BP) freilegt;
Überdecken der Mehrzahl von isolierenden Schichten (116, GI, ILD1, ILD2) mit einer Passivierungsschicht (PAS), wobei die Passivierungsschicht (PAS) durch das Durchgangsloch (VIA1, VIA2) hindurch die Pufferschicht kontaktiert; und
Ätzen der Passivierungsschicht (PAS) zum Bilden von mindestens einer Öffnung (PAH1, PAH2) in der Passivierungsschicht (PAS),
wobei das Durchgangsloch (VIA1, VIA2) und die mindestens eine Öffnung (PAH1, PAH2) jeweils als eine jeweilige geschlossene Schleife, die den Anzeigebereich (DP) umgibt, gebildet werden,
wobei das Durchgangsloch (VIA1, VIA2) ferner dazu eingerichtet ist, ein Eindringen von Feuchtigkeit durch die Sprünge hindurch zu blockieren.

7. Das Verfahren gemäß Anspruch 6, ferner aufweisend:
Ätzen der zweiten Pufferschicht (116), der Gate-isolierenden Schicht (GI), der ersten Zwischenschicht-Dielektrikumschicht (ILD1) und der zweiten Zwischenschicht-Dielektrikumschicht (ILD2) in dem Anzeigebereich (DP) zum Ausbilden von Kontaktlöchern (CH2, CH3, CH4), die die Halbleiterschicht (120) und die zweite Gate-Elektrode (135) freilegen.

## Revendications

1. Dispositif d'affichage (100), comprenant :
un substrat (110) comprenant une zone d'affichage (DP) ayant une pluralité de sous-pixels (SP) et une zone de bordure (BP) autour de la zone d'affichage (DP) ;
une pluralité de couches isolantes (116, GI, ILD1, ILD2) disposées séquentiellement sur la zone d'affichage et la zone de bordure du substrat (110), la pluralité de couches isolantes (116, GI, ILD1, ILD2) comprenant une deuxième couche tampon (116), une couche isolante de grille (GI), une première couche diélectrique intercouche (ILD1) et une deuxième couche diélectrique intercouche (ILD2) ;
au moins un trou d'interconnexion (VIA1, VIA2) traversant la pluralité de couches isolantes dans la zone de bordure, le trou d'interconnexion (VIA1, VIA2) traversant la deuxième couche tampon (116), la couche isolante de grille (GI), la première couche diélectrique intercouche (ILD1) et la deuxième couche diélectrique intercouche (ILD2) ;
une couche de passivation (PAS) positionnée sur la deuxième couche diélectrique intercouche (ILD2), la couche de passivation (PAS) contactant une première couche tampon (112) formée sous la pluralité de couches isolantes à travers le trou d'interconnexion (VIA1, VIA2) ; et
au moins une ouverture (PAH1, PAH2) traversant la couche de passivation (PAS) sur la pluralité de couches isolantes (116, GI, ILD1, ILD2) dans la zone de bordure,
dans lequel le trou d'interconnexion (VIA1, VIA2) et l'au moins une ouverture (PAH1, PAH2) entourent chacun la zone d'affichage (DP) pour former une boucle fermée respective,
dans lequel l'au moins un trou d'interconnexion (VIA1, VIA2) et l'au moins une ouverture (PAH1, PAH2) sont configurés pour supprimer la propagation de fissures dans la zone de bordure (BP), et
dans lequel le trou d'interconnexion (VIA1, VIA2) est en outre configuré pour bloquer la pénétration d'humidité à travers les fissures.

2. Dispositif d'affichage (100) selon la revendication 1, dans lequel l'ouverture (PAH1, PAH2) est séparée du trou d'interconnexion (VIA1, VIA2) pour être positionnée à l'extérieur du trou d'interconnexion (VIA1, VIA2).

3. Dispositif d'affichage (100) selon la revendication 1 ou 2, dans lequel l'ouverture (PAH1, PAH2) entoure la zone d'affichage (DP) et est positionnée parallèlement au trou d'interconnexion (VIA1, VIA2).

4. Dispositif d'affichage (100) selon la revendication 1, dans lequel l'ouverture (PAH1, PAH2) et le trou d'interconnexion (VIA1, VIA2) sont positionnés en alternance.

5. Dispositif d'affichage (100) selon l'une quelconque des revendications 1 à 4, dans lequel l'ouverture (PAH1, PAH2) et le trou d'interconnexion (VIA1, VIA2) ont une forme de boucle dans une perspective plane.

6. Procédé de fabrication d'un dispositif d'affichage (100) selon la revendication 1, comprenant les étapes suivantes consistant à :
empiler de manière séquentielle une pluralité de couches isolantes (116, GI, ILD1, ILD2) sur un substrat (110) ayant une zone d'affichage (DP) et une zone de bordure (BP),
dans lequel l'étape consistant à empiler la pluralité de couches isolantes (116, GI, ILD1, ILD2) comprend les étapes consistant à :
former une première couche tampon (112) sur le substrat (110) ;
former une deuxième couche tampon (116) sur la première couche tampon (112) ;
former une couche isolante de grille (GI) sur une couche semi-conductrice (120) sur la deuxième couche tampon (116) ;
former une première couche diélectrique intercouche (ILD1) sur une première électrode de grille (130) sur lacouche isolante de grille (GI) ; et
former une deuxième couche diélectrique intercouche (ILD2) sur une deuxième électrode de grille (135) sur la première couche diélectrique intercouche (ILD1) ;
former au moins un trou d'interconnexion (VIA1, VIA2) configuré pour supprimer la propagation de fissures dans la zone de bordure (BP) pour passer à travers la pluralité de couches isolantes (116, GI, ILD1, ILD2) dans la zone de bordure (BP),
dans lequel l'étape consistant à former le trou d'interconnexion (VIA1, VIA2) comprend l'étape consistant à :
graver la deuxième couche tampon (116), la couche isolante de grille (GI), la première couche diélectrique intercouche (ILD1) et la deuxième couche diélectrique intercouche (ILD2) pour former le trou d'interconnexion (VIA1, VIA2) exposant la première couche tampon (112) dans la zone de bordure (BP) ;
couvrir la pluralité de couches isolantes (116, GI, ILD1, ILD2) avec une couche de passivation (PAS), la couche de passivation (PAS) contactant la première couche tampon (112) à travers le trou d'interconnexion (VIA1, VIA2) ; et
graver la couche de passivation (PAS) pour former au moins une ouverture (PAH1, PAH2) dans la couche de passivation (PAS),
dans lequel le trou d'interconnexion (VIA1, VIA2) et l'au moins une ouverture (PAH1, PAH2) sont chacun formés comme une boucle fermée respective entourant la zone d'affichage (DP),
dans lequel le trou d'interconnexion (VIA1, VIA2) est en outre configuré pour bloquer la pénétration d'humidité à travers les fissures.

7. Procédé selon la revendication 6, comprenant en outre l'étape consistant à :
graver ladeuxième couche tampon (116), la couche isolante de grille (GI), la première couche diélectrique intercouche (ILD1) et la deuxième couche diélectrique intercouche (ILD2) dans la zone d'affichage (DP) pour former des trous de contact (CH2, CH3, CH4) exposant la couche semi-conductrice (120), et la deuxième électrode de grille (135).
